# EUROPÄISCHE PATENTSCHRIFT

(11) **EP 1 363 400 B1**
(45) Veröffentlichungstag und Bekanntmachung des Hinweises auf die Patenterteilung: **12.07.2017**
(21) Anmeldenummer: 03010235.4
(22) Anmeldetag: 07.05.2003
(51) Int. Cl.: H03K 17/95

(54) **Sicherheitsschalter**
Safety switch
Interrupteur de sécurité

(30) Priorität: 18.05.2002 DE 10222186
(43) Veröffentlichungstag der Anmeldung: 19.11.2003
(73) Patentinhaber: K.A. SCHMERSAL GmbH & Co., D-42279 Wuppertal (DE)
(72) Erfinder: Hoepken, Hermann, 45549 Sprockhövel (DE)
(74) Vertreter: Sparing Röhl Henseler

(56) Entgegenhaltungen:
- WO-A-96/08794
- DE-C1- 10 043 237
- US-A- 3 816 709
- US-B1- 6 409 083

## Beschreibung

Die Erfindung betrifft einen Sicherheitsschalter nach dem Oberbegriff des Anspruchs 1.

Ein derartiger Sicherheitsschalter ist aus DE 197 11 588 A1 bekannt. Der bekannte Sicherheitsschalter ist durch einen Betätiger in Form eines passiven Transponders mit einer eindeutigen Kennung aktivierbar, die induktiv an den Sicherheitsschalter übermittelt und mit einer gespeicherten Kennung verglichen wird. Der passive Transponder ist aufwendig und daher teuer, denn er benötigt aufgrund der komplexen Sendeoperation einen Mikroprozessor und einen Festwertspeicher sowie Bauelemente, um aus der vom Sicherheitsschalter in den Betätiger induzierten Wechselspannung die zum Betrieb des Mikroprozessors erforderliche Gleichspannung zu gewinnen. Zudem ist eine Abstandsbestimmung zum Betätiger nicht möglich, so dass weder der Schaltabstand einfach und manipulationssicher an die jeweiligen Anforderungen anpaßbar ist, noch mehrere, abstandsabhängige Schaltvorgänge durchführbar sind. Vielmehr kann der zum Schalten erforderliche Abstand zum Betätiger nur durch Ändern der Sendeleistung bzw. der Empfangsempfindlichkeit und mithin nur durch Ändern bzw. Einstellen der Beschaltung des Sicherheitsschalters bzw. Transponders an die jeweiligen Anforderungen angepaßt werden.

Aus der DE 100 43 237 C1 ist ebenfalls ein derartiger Sicherheitsschalter bekannt, bei dem eine Auswerteschaltung eine von einem Betätiger in einem Empfangselement induzierte Spannung bezüglich ihrer Frequenz zur eindeutigen Identifizierung des Betätigers und bezüglich ihrer Amplitude zur Feststellung, ob der Betätiger einen Mindestabstand unterschreitet, auswertet.

Aus WO 96/08794 A ist ein Sicherheitsschalter nach dem Oberbegriff des Anspruchs 1 bekannt.

Aufgabe der Erfindung ist es, einen Sicherheitsschalter nach dem Oberbegriff des Anspruchs 1 zu schaffen, der manipulationssicher mit einem einfach aufgebauten Betätiger betätigbar ist und dessen Schaltabstand einfach und manipulationssicher einstellbar ist.

Diese Aufgabe wird entsprechend den Merkmalen des Anspruchs 1 gelöst.

Hierzu umfaßt der Sicherheitsschalter ein Sendeelement, beispielsweise eine Spule, die über einen vorbestimmten Zeitraum elektromagnetische Signale mit einer durch die Dimensionierung der Bauteile gegebenen Sendeleistung emittiert. Ein LC-Schwingkreis in einem Betätiger wird hierdurch zum Schwingen angeregt und speichert einen von seiner Entfernung zum Sicherheitsschalter abhängigen Teil der gesendeten Energiemenge. Die so gespeicherte Energie wird anschließend in Form elektromagnetischer Wellen mit der Frequenz des LC-Schwingkreises vom Betätiger abgestrahlt. Ein wiederum von Abstand zwischen Betätiger und Sicherheitsschalter abhängiger Teil dieser Energie wird anschließend in einem Empfangselement, zweckmäßigerweise derselben Spule, des Sicherheitsschalters in Form einer elektrischen Wechselspannung induziert. Integriert über einen vorbestimmten Zeitraum ergibt sich eine am Empfangselement induzierte Energiemenge, die ein Maß für den Abstand zwischen dem Sicherheitsschalter und dem Betätiger ist. Durch den Vergleich der empfangenen Energiemenge mit einem insbesondere durch Software einstellbaren Schwellenwert ist der Schaltabstand ohne Änderung oder Justierung der Beschaltung beliebig einstellbar.

Der Sicherheitsschalter benötigt nur einen einfach aufgebauten Betätiger, der aus lediglich einem LC-Schwingkreis beispielsweise in Form einer Spule mit einer durch das Spulenmaterial gegebenen Kapazität bestehen kann.

Die Manipulationssicherheit gegen Aktivierung mit anderen Betätigern ist gewährleistet, da wegen der Frequenzabhängigkeit der Energieaufnahme des LC-Schwingkreises nur ein auf die Sendefrequenz des Sicherheitsschalters abgestimmter Betätiger mit der für die Erkennung erforderlichen Energiemenge angeregt werden kann. Andere Betätiger, die LC-Schwingkreise mit hiervon abweichenden Schwingungsfrequenzen aufweisen, werden hingegen nicht stark genug angeregt und können den Sicherheitsschalter nicht aktivieren.

Zur besseren Unterscheidung verschiedener Betätiger und zur Erhöhung der Manipulationssicherheit kann eine Frequenz-Erkennungsschaltung vorgesehen sein, die die Frequenz der induzierten elektrischen Energie und damit die Schwingungsfrequenz des LC-Schwingkreises im Betätiger erkennt. Hierdurch ist es möglich, Betätigern eindeutige Kennungen zuzuweisen.

Der Sicherheitsschalter arbeitet vorzugsweise zyklisch, wobei ein Arbeitszyklus zweckmäßigerweise stets mit einer Funktionsprüfung beginnt, an welche sich ein Sende- und ein Empfangszyklus anschließen. Die Funktionsprüfung stellt hierbei eine sicherheitsgerichtete Erkennung aller Bauteile während des Betriebs sicher. Zudem ist bei Beschädigung des Betätigers ein Übergang des Sicherheitsschalters in den sicheren Zustand gewährleistet, da diese eine Verringerung der speicherbaren Energie und/oder eine Änderung der LC-Schwingkreisfrequenz und somit der Kodierung zur Folge hat.

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt schematisch einen Sicherheitsschalter und einen Betätiger.
Fig. 2 zeigt den Spannungsverlauf am Sendeelement und am Empfangselement des Sicherheitsschalters als Funktion der Zeit.
Fig. 3 zeigt schematisch eine zweikanalige Ausführungsform eines Sicherheitsschalters.

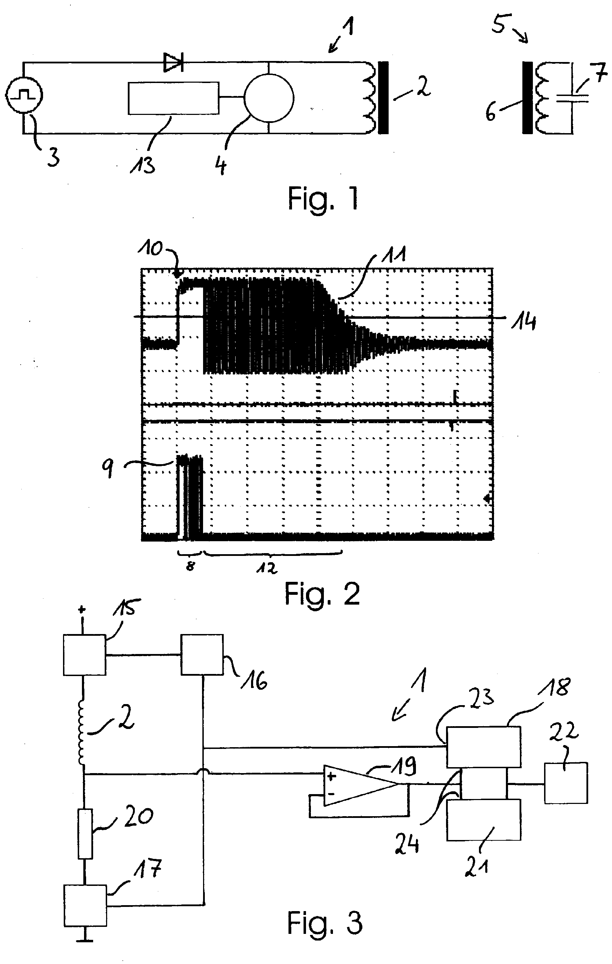

Der in Fig. 1 gezeigte Sicherheitsschalter 1 umfaßt eine Sende- und Empfangsspule 2, die von einer Steuerung 3 zum Emittieren elektromagnetischer Signale anregbar und an eine Auswerteschaltung 4 zum Auswerten induzierter elektrischer Signale gekoppelt ist. Der dargestellte Betätiger 5 umfaßt einen eine Sende- und Empfangsspule 6 und einen Kondensator 7 umfassenden LC-Schwingkreis.

Die Steuerung 3 erzeugt während eines Sendezyklus 8, vgl. Fig. 2, elektrische Signale vorzugsweise in Form elektrischer Spannungsimpulse 9 zwischen zwei vorbestimmten Spannungswerten, z.B. zwischen Masse und positiver Betriebsspannung, die zu einem Spannungsverlauf 10 an der Sende- und Empfangsspule 2 führen. Die Steuerung 3 kann jedoch auch statt dessen Stromimpulse oder eine Wechselspannung oder einen Wechselstrom erzeugen. Die Frequenz der elektrischen Signale ist vorzugsweise so bemessen, daß die hierdurch erzeugten elektromagnetischen Signale Metallteile durchdringen können, so daß sowohl der Sicherheitsschalter 1 als auch der Betätiger 5 beispielsweise hinter Maschinenverkleidungsteilen geschützt angebracht werden können.

Die in Form elektromagnetischer Signale von der Sende- und Empfangsspule 2 des Sicherheitsschalters 1 emittierte Energiemenge E₁ ist das Produkt aus Sendeleistung und Dauer des Sendezyklus 8 und proportional zum Integral der Spannungspulse 9 über den Sendezyklus 8. Die elektromagnetischen Signale induzieren in der Sende- und Empfangsspule 6 des Betätigers 5 eine elektrische Energiemenge E₂. E₂ ist eine Funktion des Abstands zwischen Sicherheitsschalter 1 und Betätiger 5 und hängt darüber hinaus von einem konstanten Induktionskopplungsfaktor ab, der durch die Differenz zwischen Sendefrequenz und der LC-Schwingungsfrequenz sowie Materialkonstanten festgelegt wird.

Nach Beendigung des Sendezyklus 8 schwingt der LC-Schwingkreis frei und emittiert dabei die gespeicherte Energiemenge E₂ in Form elektromagnetischer Wellen, die eine Wechselspannung 11 in der Sende- und Empfangsspule 2 induzieren.

Während eines sich vorzugsweise unmittelbar an den Sendezyklus 8 anschließenden Empfangszyklus 12 wird so eine Energiemenge E₃ im Sicherheitsschalter 1 empfangen, die proportional zum Integral der Wechselspannung 11 über die Dauer des Empfangszyklus 12 ist. E₃ ist eine Funktion des Abstands zwischen Sicherheitsschalter 1 und Betätiger 5 und hängt darüber hinaus von einem konstanten, materialabhängigen Induktionskopplungsfaktor ab. Somit ist das Verhältnis von E₃ zu E₁ ein Maß für diesen Abstand.

E₁ kann so hoch gewählt sein, daß E₂ auch bei maximaler Entfernung des Betätigers zum Sicherheitsschalter, beispielsweise bei vollständig geöffneter Tür zu einem zu sichernden Bereich, die im LC-Schwingkreis maximal speicherbare Energiemenge E_{LC} übersteigt. Hierdurch wird erreicht, daß der Betätiger 5 unabhängig von seiner Position immer mit der selben Energiemenge E_{LC} angeregt wird, so daß die Entfernung allein vom Verhältnis von E₃ zu E_{LC} abhängt. Hierbei ist es vorteilhaft, wenn der LC-Schwingkreis so dimensioniert ist, daß E₃ auch bei maximaler Entfernung des Betätigers 5 zum Sicherheitsschalter, beispielsweise bei vollständig geöffneter Tür zu einem zu sichernden Bereich, nachweisbar ist. Dann können unabhängig von der Position des Betätigers 5 sein Vorhandensein und seine Funktionsfähigkeit geprüft sowie externe Störfelder erkannt werden.

Die Auswerteschaltung 4 erfaßt die Energiemenge E₃ und vergleicht diese mit einem Schwellenwert, der einem bestimmten Abstand zwischen Betätiger 5 und Sicherheitsschalter 1 entspricht. Bei Über- oder Unterschreiten des Schwellenwertes wird ein Schaltsignal für eine Schalteinrichtung 13 erzeugt und ein Sicherheitskontakt geöffnet bzw. geschlossen. Der Schwellenwert kann werkseitig voreingestellt, vor der Montage des Sicherheitsschalters 1 einstellbar und/oder zweckmäßigerweise durch einen Mikroprozessor veränderbar, insbesondere an die im Betrieb gemessenen Energiemengen anpaßbar, sein. Es können auch mehrere Schwellenwerte eingestellt werden, um abstandsabhängig verschiedene Schaltvorgänge durchzuführen, um beispielsweise verschiedene Schalteinrichtungen 13 anzusteuern.

Zum näherungsweisen Integrieren der induzierten elektrischen Signale über den Empfangszyklus 12 umfaßt die Auswerteschaltung 4 einen Trigger, der einen elektrischen Impuls erzeugt, wenn die Amplitude der induzierten Wechselspannung 11 einen Schwellenwert überschreitet, sowie einen dem Trigger nachgeschalteten Zähler. Die Anzahl derjenigen Perioden der induzierten Wechselspannung 11, die eine Mindestamplitude 14 aufweisen, ist ein Maß für den Abstand zwischen Betätiger 5 und Sicherheitsschalter 1, da die Höhe und der zeitliche Verlauf der Wechselspannung 11 abstandsabhängig sind. Die Anzahl entspricht dem oben genannten Schwellenwert, der zum Erzeugen des Schaltsignal über- oder unterschritten werden muß.

Die Auswerteschaltung 4 kann auch eine Frequenz-Erkennungsschaltung zum Erfassen der Frequenz der induzierten Wechselspannung 11 und somit der LC-Schwingungsfrequenz umfassen, so daß eine genaue Erkennung des Betätigers 5 möglich ist. Hierzu ist der Trigger an einen Zeitgeber gekoppelt, der die Zeitspanne zwischen zwei aufeinanderfolgenden Impulsen erfaßt. Ein Erkennungssignal wird erzeugt, wenn die Zeitspanne, gegebenenfalls über mehrere Perioden betrachtet, zwischen einem unteren und einem oberen Schwellenwert liegt, oder wenn die Anzahl der während einer vorbestimmten Zeitspanne erfaßten Impulse zwischen einem unteren und einem oberen Schwellenwert liegt. Das Erkennungssignal wird zusammen mit dem Schaltsignal einem der Schalteinrichtung 13 vorgeschalteten UND-Gatter zugeführt, so daß die Schalteinrichtung 13 nur dann aktiviert wird, wenn beide Signale vorliegen.

Anstelle der kombinierten Sende- und Empfangsspulen 2, 6 können auch getrennte Spulen und/oder Dipole od. dgl. vorgesehen sein.

Der in Fig. 3 gezeigte zweikanalige Sicherheitsschalter 1 umfaßt eine kombinierte Sende- und Empfangsspule 2, die über Schaltelemente 15, 16, 17, z.B. Transistoren, und einen Mikroprozessor 18 zum Emittieren elektromagnetischer Signale aktivierbar ist. Zum Auswerten induzierter Spannung ist die Sende- und Empfangsspule 2 über einen Operationsverstärker 19, der die an einem Meßwiderstand 20 abfallende Spannung verstärkt, an den Mikroprozessor 18 und einen weiteren Mikroprozessor 21 für den zweiten Kanal, gekoppelt. Die Mikroprozessoren 18, 21 erzeugen unabhängig voneinander das Schaltsignal, das über eine Treiberschaltung 22 am Anschluß des Sicherheitsschalters 1 bereitgestellt wird.

Vorzugsweise wird zunächst eine Funktionsprüfung durchgeführt, an die sich ein Sendezyklus 8 und ein Empfangszyklus 12 anschließen.

Die Funktionsprüfung beginnt durch Versetzen der beiden Schaltelemente 16, 17 in den leitenden Zustand durch den Mikroprozessor 18, um das Schaltelement 15 als Konstantstromquelle zu schalten, die den Spulenkreis mit einem konstanten Strom versorgt. Die über den Meßwiderstand 20 abfallende Spannung wird nach Verstärkung durch den Operationsverstärker 19 durch einen Analog/Digital-Wandler im Mikroprozessor 18 auf Einhalten von Grenzwerten überprüft. Hierdurch werden die Konstantstromquelle, die Sende- und Empfangsspule 2, der Operationsverstärker 19 und seine Beschaltung sowie der Analog/Digital-Wandler überprüft.

Bei erfolgreicher Überprüfung erzeugt der Mikroprozessor 18 während des Sendezyklus 8 an seinem Ausgang 23 eine Folge von Spannungsimpulsen mit einer der LC-Schwingungsfrequenz eines Betätigers 5 entsprechenden Frequenz. Der LC-Schwingkreis wird so mit Energie geladen.

Nach dem Sendezyklus 8 geht Ausgang 23 auf LOW, so daß der Betätiger 5 ungestört Spannung in die Sende- und Empfangsspule 2 induzieren kann. Diese Spannung wird vom Operationsverstärker 19 verstärkt und an nun als Schmitt-Trigger konfigurierte Eingänge 24 der Mikroprozessoren 18, 21 angelegt, die diese Spannung in Impulse umwandeln. Jeder Impuls löst einen Interrupt in den Mikroprozessoren 18, 21 aus. Die Anzahl der Interrupts während des Empfangszyklus 12 gibt den Abstand zwischen Betätiger 5 und Sicherheitsschalter 1 an und wird zum Erzeugen des Schaltsignals benutzt. Die Zeit zwischen zwei Interrupts ist ein Maß für die Frequenz des LC-Schwingkreises, um festzustellen, ob der Betätiger 5 korrekt kodiert ist.

## Patentansprüche

1. Sicherheitsschalter (1) mit einer Erkennungseinrichtung für einen Betätiger (5), die an eine Schalteinrichtung (13) gekoppelt ist und ein Sendeelement (2) zum Emittieren elektromagnetischer Signale und eine Auswerteschaltung (4) umfasst, welche in Abhängigkeit von an einem Empfangselement (2) induzierten elektrischen Signalen ein Schaltsignal zum Aktivieren der Schalteinrichtung (13) erzeugt, wozu die Auswerteschaltung (4) einen Integrator, der zum Erfassen der während einer dem Emittieren folgenden Zeitspanne im Empfangselement (2) induzierten elektrischen Energiemenge an einen Zeitgeber gekoppelt ist, und eine Vergleichseinrichtung umfasst, die das Schaltsignal bereitstellt, wenn die Energiemenge einen vorbestimmten Schwellenwert über- oder unterschreitet und der Integrator einen Trigger zum Erzeugen eines elektrischen Impulses, wenn die Amplitude der induzierten Spannung und/oder des induzierten Stroms einen Schwellenwert überschreiten, umfasst, wobei die induzierte elektrische Energiemenge mit einem auf einer Frequenz frei schwingenden LC-Schwingkreis in dem Betätiger (5) abgestrahlt wird und somit ein Maß für den Abstand zwischen dem Sicherheitsschalter (1) und dem Betätiger (5) ist,
**dadurch gekennzeichnet, dass**, der Integrator einen Zähler mit einem an den Trigger gekoppelten Eingang für die elektrischen Impulse umfasst und die Vergleichseinrichtung an den Zeitgeber und den Zähler gekoppelt und zum Erzeugen des Schaltsignals, wenn der Zählerstand nach Ablauf der Zeitspanne einen vorbestimmten Wert unter- oder überschreitet, ausgestaltet ist.

2. Sicherheitsschalter nach Anspruch 1, **gekennzeichnet durch** eine an den Trigger und einen Zeitgeber gekoppelte Frequenz-Erkennungsschaltung zum Erzeugen eines Erkennungssignals, wenn die Zeitspanne zwischen zwei aufeinanderfolgenden Impulsen zwischen einem unteren und einem oberen Schwellenwert liegt.

3. Sicherheitsschalter nach Anspruch 1 oder 2, **gekennzeichnet durch** eine an den Zähler und einen Zeitgeber gekoppelte Frequenz-Erkennungseinrichtung zum Erzeugen eines Erkennungssignals, wenn die Anzahl der in einer Zeitspanne erfaßten Impulse zwischen einem unteren und einem oberen Schwellenwert liegt.

4. Sicherheitsschalter nach Anspruch 2 oder 3, **gekennzeichnet durch** ein der Schalteinrichtung vorgeschaltetes und das Schaltsignal mit dem Erkennungssignal UND-verknüpfendes Gatter.

5. Sicherheitsschalter nach einem der Ansprüche 1 bis 4, **dadurch gekennzeichnet, daß** das Sende- und das Empfangselement (2) eine gemeinsame oder jeweils separate Spule und/oder Antenne sind.

6. Sicherheitsschalter nach einem der Ansprüche 1 bis 5 **dadurch gekennzeichnet, daß** das Sendeelement (2) von einer Steuerung (3) mit positiven Spannungspulsen oder mit einer Wechselspannung gespeist wird.

7. Sicherheitsschalter nach einem der Ansprüche 1 bis 6, **dadurch gekennzeichnet, daß** die Frequenz der emittierten Signale gleich der Schwingungsfrequenz eines LC-Schwingkreises im Betätiger (5) ist.

## Claims

1. Safety switch (1) having a detection device for an actuator (5), which detection device is coupled to a switching device (13) and comprises a transmitting element (2) for emitting electromagnetic signals and an evaluation circuit (4) which generates a switching signal for activating the switching device (13) on the basis of electrical signals induced at a receiving element (2), for which purpose the evaluation circuit (4) comprises an integrator, which is coupled to a timer for the purpose of capturing the amount of electrical energy induced in the receiving element (2) during a period following the emission, and a comparison device which provides the switching signal if the amount of energy exceeds or falls below a predetermined threshold value, and the integrator comprises a trigger for generating an electrical pulse if the amplitude of the induced voltage and/or of the induced current exceeds a threshold value, the induced amount of electrical energy being emitted using an LC resonant circuit oscillating freely at a frequency in the actuator (5) and therefore being a measure of the distance between the safety switch (1) and the actuator (5), **characterized in that**
the integrator comprises a counter having an input for the electrical pulses which is coupled to the trigger, and the comparison device is coupled to the timer and to the counter and is configured to generate the switching signal if the counter reading falls below or exceeds a predetermined value after expiry of the period.

2. Safety switch according to Claim 1, **characterized by** a frequency detection circuit which is coupled to the trigger and to a timer and is intended to generate a detection signal if the period between two successive pulses is between a lower threshold value and an upper threshold value.

3. Safety switch according to Claim 1 or 2, **characterized by** a frequency detection device which is coupled to the counter and to a timer and is intended to generate a detection signal if the number of pulses captured in a period is between a lower threshold value and an upper threshold value.

4. Safety switch according to Claim 2 or 3, **characterized by** a gate which is connected upstream of the switching device and ANDs the switching signal with the detection signal.

5. Safety switch according to one of Claims 1 to 4, **characterized in that** the transmitting element and the receiving element (2) are a common coil and/or antenna or are each a separate coil and/or antenna.

6. Safety switch according to one of Claims 1 to 5, **characterized in that** the transmitting element (2) is fed with positive voltage pulses or with an AC voltage by a controller (3).

7. Safety switch according to one of Claims 1 to 6, **characterized in that** the frequency of the emitted signals is the same as the oscillation frequency of an LC resonant circuit in the actuator (5).

## Revendications

1. Interrupteur de sécurité (1) avec un dispositif de reconnaissance pour un actionneur (5), lequel dispositif de reconnaissance est couplé à un dispositif de commutation (13) et comprend un élément émetteur (2) servant à émettre des signaux électromagnétiques et un circuit d'évaluation (4), qui produit, en fonction de signaux électriques induits au niveau d'un élément récepteur (2), un signal de commutation servant à activer le dispositif de commutation (13), le circuit d'évaluation (4) comprenant à cet effet un intégrateur, qui est couplé à un minuteur afin de détecter la quantité d'énergie électrique induite dans l'élément récepteur (2) au cours d'un laps de temps suivant l'émission, et un dispositif de comparaison, qui fournit le signal de commutation, quand la quantité d'énergie n'atteint pas ou dépasse une valeur de seuil prédéfinie et l'intégrateur comprenant un déclencheur servant à produire une impulsion électrique quand l'amplitude de la tension induite et/ou du courant induit dépasse une valeur de seuil, dans lequel la quantité d'énergie électrique induite est irradiée dans l'actionneur (5) avec un circuit oscillant LC oscillant librement à une fréquence et est ce faisant une mesure pour la distance entre l'interrupteur de sécurité (1) et l'actionneur (5),
**caractérisé en ce que**
l'intégrateur comprend un compteur avec une entrée couplée au déclencheur pour les impulsions électriques,
et le dispositif de comparaison est couplé au minuteur et au compteur et est configuré afin de produire le signal de commutation quand le relevé du compteur n'atteint pas ou dépasse une valeur prédéfinie à l'issue d'un laps de temps.

2. Interrupteur de sécurité selon la revendication 1, **caractérisé par** un circuit de reconnaissance de fréquence couplé au déclencheur et à un minuteur servant à produire un signal de reconnaissance quand le laps de temps entre deux impulsions se suivant l'une l'autre se situe entre une valeur de seuil inférieure et une valeur de seuil supérieure.

3. Interrupteur de sécurité selon la revendication 1 ou 2, **caractérisé par** un dispositif de reconnaissance de fréquence couplé au compteur et à un minuteur servant à produire un signal de reconnaissance quand le nombre des impulsions détectées dans un laps de temps se situe entre une valeur de seuil inférieure et une valeur de seuil supérieure.

4. Interrupteur de sécurité selon la revendication 2 ou 3, **caractérisé par** une grille montée en amont du dispositif de commutation et combinant par une liaison ET le signal de commutation au signal de reconnaissance.

5. Interrupteur de sécurité selon l'une quelconque des revendications 1 à 4, **caractérisé en ce que** l'élément émetteur et l'élément récepteur (2) sont une bobine et/ou une antenne commune ou respectivement séparée.

6. Interrupteur de sécurité selon l'une quelconque des revendications 1 à 5, **caractérisé en ce que** l'élément émetteur (2) est alimenté par une commande (3) en impulsions de tension positives ou en une tension alternative.

7. Interrupteur de sécurité selon l'une quelconque des revendications 1 à 6, **caractérisé en ce que** la fréquence des signaux émis est identique à la fréquence d'oscillation d'un circuit oscillant LC dans l'actionneur (5).
